# EUROPEAN PATENT APPLICATION

(11) **EP 4 685 558 A2**
(43) Date of publication of application: **28.01.2026**
(21) Application number: 25189904.3
(22) Date of filing: 16.07.2025
(51) Int. Cl.: G03F 7/00

(54) **DIGITAL BIASING AND DIGITAL CELL PLACEMENT TECHNIQUE FOR SEMICONDUCTOR PACKAGING**

(30) Priority: 25.07.2024 US 202463675671 P
(71) Applicant: Applied Materials, Inc., Santa Clara, CA 95054 (US)
(72) Inventor: ZHONG, Qin, Santa Clara 95054 (US); LAIDIG, Thomas L., Santa Clara 95054 (US); KANG, Chung-Shin, Santa Clara 95054 (US)
(74) Representative: Zimmermann & Partner Patentanwälte mbB

(57) **Abstract**

Embodiments of the present disclosure relate to a method of digital lithography for semiconductor packaging and a software application. The method includes receiving metrology data to a digital lithography system, the metrology data corresponding to the pillar heights and pillar critical dimensions of a plurality of non-uniform pillars disposed over the die, wherein at least two pillars have different pillar heights and different pillar critical dimensions, the digital lithography system is operable to update a mask pattern, the mask pattern corresponding to a pattern of uniform pillars, updating the mask pattern according to the metrology data to generate a compensated mask pattern, and conducting a digital lithography process to pattern on a resist to form a plurality of vias, the vias are formed over each non-uniform pillar of the plurality of non-uniform pillars and include a via depth and a via critical dimension after the resist is developed.

## Description

### BACKGROUND

### Field

Embodiments of the present disclosure generally relate to digital lithography systems. More particularly, embodiments of the present disclosure relate to a system, a software application, and a method of digital lithography for semiconductor packaging.

### Description of the Related Art

Electronic packaging and assembly are typically used to link the small dimensions of an integrated circuit (IC) to an interconnecting substrate, for example, a printed circuit board (PCB) or an interposer. The PCB usually includes a number of passive components and ICs to build a microelectronic device, and the interposer is a connection board embedded into a packaged chip with a plurality of chiplet ICs on the interposer. As the semiconductor industry has experienced rapid growth due to ongoing improvements in the integration density of a variety of electronic components, for example, transistors, diodes, resistors, and capacitors. For the most part, improvement in integration density has resulted from iterative reduction of minimum feature size, which allows more components to be integrated into a given area. As the demand for shrinking electronic devices has grown, a need for smaller and more creative packaging techniques of semiconductor dies has emerged.

For the foregoing reasons, there is a need for a system, a software application, and method of digital lithography for semiconductor packaging.

### SUMMARY

Embodiments of the present disclosure generally relate to digital lithography systems. More particularly, embodiments of the present disclosure relate to a system, a software application, and a method of digital lithography for semiconductor packaging.

In one embodiment, a method is provided. The method includes receiving metrology data to a digital lithography system, the metrology data corresponding to the pillar heights and pillar critical dimensions of a plurality of non-uniform pillars disposed over the die, wherein at least two pillars have different pillar heights and different pillar critical dimensions, the digital lithography system including a controller that is operable to update a mask pattern, the mask pattern corresponding to a pattern of uniform pillars, updating the mask pattern according to the metrology data to generate a compensated mask pattern based on the different pillar heights and the different pillar critical dimensions, and conducting a digital lithography process to pattern on a resist according to the compensated mask pattern to form a plurality of vias, the vias are formed over each non-uniform pillar of the plurality of non-uniform pillars and include a via depth and a via critical dimension after the resist is developed.

In another embodiment, a second method is provided. The second method including conducting a metrology scan to determine a pillar height and a pillar critical dimension of a plurality of non-uniform pillars disposed over a die, the metrology scan generating metrology data corresponding to the pillar heights and the pillar critical dimensions, the metrology data generating a compensated mask pattern, conducting a digital lithography process according to the compensated mask pattern to form a plurality of vias, the vias are formed over each non-uniform pillar of the plurality of non-uniform pillars and include a via depth and via critical dimension, and conducting a solder plating process, the solder plating process filling each via in the plurality of vias with a solder bump, each solder bump secured to one non-uniform pillar of the plurality of non-uniform pillars.

In another embodiment, a non-transitory computer-readable medium storing instructions that, when executed by a processor, cause a computer system to perform a method. The method executed by a processor of a non-transitory computer-readable medium including receiving metrology data to a digital lithography system, the metrology data corresponding to the pillar heights and pillar critical dimensions of a plurality of non-uniform pillars disposed over the die, wherein at least two pillars have different pillar heights and different pillar critical dimensions, the digital lithography system including a controller that is operable to update a mask pattern, the mask pattern corresponding to a pattern of uniform pillars, updating the mask pattern according to the metrology data to generate a compensated mask pattern based on the different pillar heights and the different pillar critical dimensions, conducting a digital lithography process to pattern on a resist according to the compensated mask pattern to form a plurality of vias, the vias are formed over each non-uniform pillar of the plurality of non-uniform pillars and include a via depth and a via critical dimension after the resist is developed.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments.
Figure 1 is a schematic diagram of a digital lithography system in accordance with one or more embodiments described herein.
Figure 2 is a perspective view of a digital lithography device in accordance with one or more embodiments described herein.
Figure 3A is a schematic, cross-sectional of a packaging substrate in accordance with one or more embodiments described herein.
Figure 3B is a schematic, top view of a packaging substrate in accordance with one or more embodiments described herein.
Figure 4 is a flow diagram of a digital lithography method in accordance with one or more embodiments described herein.
Figures 5A-5E are a schematic, cross-sectional of a die during operations of a digital lithography method in accordance with one or more embodiments described herein.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present disclosure generally relate to digital lithography systems. More particularly, embodiments of the present disclosure relate to a system, a software application, and method of digital lithography for semiconductor packaging.

In the advanced packaging industry, it is important to maintain process uniformity of the pillars. If uniformity is not maintained, it may result in degraded performance and/or reliability as proper connection between the solder bumps of the non-uniform pillars and a circuit board may not be formed. To maintain process uniformity a digital mask is updated for the desired pattern at a local level. In the method disclosed herein, a compensated mask pattern is patterned over a resist and allows for the volume of solder plating to be controlled to compensate for the non-uniformity of the pillars. Traditional methods of optimization upstream or downstream cannot compensate for the non-uniformity if the non-uniformity is random and localized. Thus, a digital solution is required to maintain uniformity of pillars by planarization in the advanced packaging industry.

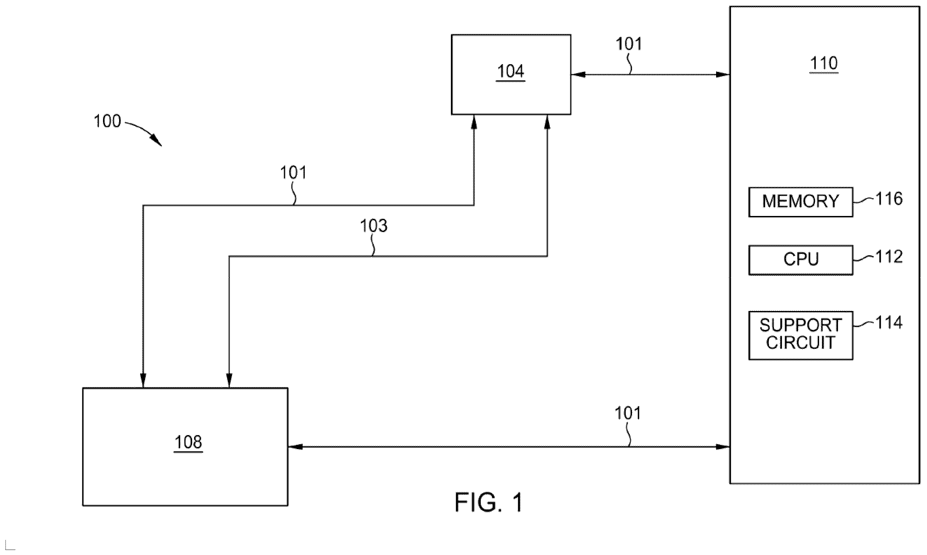

Figure 1 is a schematic diagram of a digital lithography system 100. As shown, the digital lithography system 100 includes, but is not limited to, a metrology device 104, a digital lithography device 108, a controller 110, and a plurality of communication links 101. The digital lithography device 108 may be a maskless digital lithography device. The digital lithography system 100 may further include a transfer system 103. The digital lithography device 108 and the metrology device 104 may be connected by the transfer system 103. The transfer system is operable to transfer a substrate between the digital lithography device 108 and the metrology device 104.

Each of the digital lithography system devices (the metrology device 104 and the digital lithography device 108) are operable to be connected to the controller 110 via the communication links 101. The digital lithography system 100 can be located in the same area or production facility, or the each of the digital lithography system devices can be located in different areas.

Each of the plurality of digital lithography system devices are additionally indexed with digital connection method. Each metrology device 104, digital lithography device 108, and controller 110 include an on-board processor and memory, where the memory is configured to store instructions corresponding to any portion of the digital lithography method 400 described below. The communication links 101 may include at least one of wired connections, wireless connections, satellite connections, and the like. The communications links 101 facilitate sending and receiving files to store data, according to embodiments further described herein. Transfer of data along communications links 101 can include temporarily or permanently storing files or data in the cloud, before transferring or copying the files or data to a digital lithography environment device.

The controller 110 includes a central processing unit (CPU) 112, support circuits 114 and memory 116. The CPU 112 can be one of any form of computer processor that can be used in an industrial setting for controlling the digital lithography system devices. The memory 116 is coupled to the CPU 112. The memory 116 can be one or more of readily available memory, such as random access memory (RAM), read only memory (ROM), floppy disk, hard disk, or any other form of digital storage, local or remote. The support circuits 114 are coupled to the CPU 112 for supporting the processor in a conventional manner. These circuits include cache, power supplies, clock circuits, input/output circuitry, subsystems, and the like. The controller 110 can include the CPU 112 that is coupled to input/output (I/O) devices found in the support circuits 114 and the memory 116. The controller 110 is operable to facilitate and transfer a design file to the digital lithography device 108 via the communication links 101.

The memory 116 can include one or more software applications, such as a controlling software program. The memory 116 can also include stored media data that is used by the CPU 112 to perform the digital lithography method 400 described herein. The CPU 112 can be a hardware unit or combination of hardware units capable of executing software applications and processing data. In some configurations, the CPU 112 includes a central processing unit (CPU), a digital signal processor (DSP), an application-specific integrated circuit (ASIC), and/or a combination of such units. The CPU 112 is generally configured to execute the one or more software applications and process the stored media data, which can be each included within the memory 116. The controller 110 controls the transfer of data and files to and from the various digital lithography system devices. The memory 116 is configured to store instructions corresponding to any operation of the digital lithography method 400 according to embodiments described herein.

The metrology device 104 may include software and hardware to measure pillar heights 316 and pillar critical dimensions 318. The pillar critical dimension 318 is a width or diameter of the non-uniform pillars 306. The metrology device 104 is operable to convert pillar heights 316 and pillar critical dimensions 318 into a metrology data format, and transfer the metrology data to the controller 110. The metrology data generated from the metrology device 104 may be sent to the controller 110 via the communication link 101. The controller 110 may update a mask pattern with the metrology data generated via the metrology device 104 to generate a compensated mask pattern as further described in the digital lithography method 400. The digital lithography device 108 patterns the resist 322, e.g., preforms a digital lithography process, according to the compensated mask pattern.

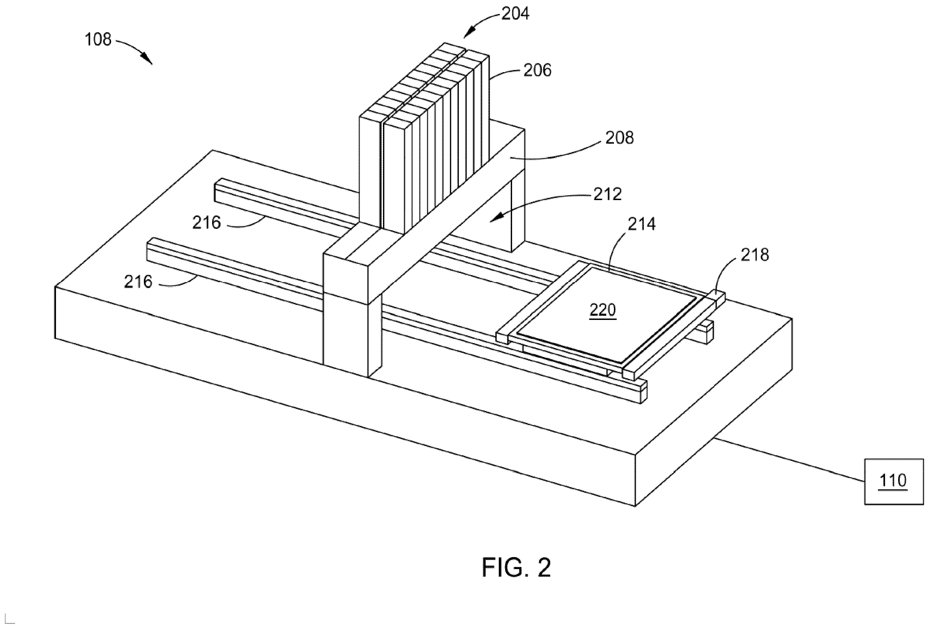

Figure 2 is a perspective view of a digital lithography device 108, such as a digital lithography system 100, that may benefit from embodiments described herein. The digital lithography device 108 includes a stage 214 and a processing unit 204. The stage 214 is supported by a pair of tracks 216. A packaging substrate 220 is supported by the stage 214. The stage 214 is operable to move along the pair of tracks 216. An encoder 218 is coupled to the stage 214 in order to provide information of the location of the stage 214 to a controller 110.

The controller 110 is generally designed to facilitate the control and automation of the processing techniques described herein. The controller 110 may be coupled to or in communication with the processing unit 204, the stage 214, and the encoder 218. The processing unit 204 and the encoder 218 may provide information to the controller 110 regarding the substrate processing and the substrate aligning. For example, the processing unit 204 may provide information to the controller 110 that substrate processing has been completed. The controller 110 facilitates the control and automation of a digital lithography process based on a design file. The design file (or computer instructions), which may be referred to as an imaging design file, readable by the controller 110, determines which tasks are to be performed on a substrate. The design file includes mask pattern data. The mask pattern data includes a mask pattern and code to monitor and control the processing time and substrate position. The mask pattern corresponds to a pattern to be written using the electromagnetic radiation. As described in the digital lithography method 400, the controller 110 updates the mask pattern with metrology data to generate a compensated mask pattern.

The packaging substrate 220 comprises any suitable material, for example, glass. In other embodiments, which can be combined with other embodiments described herein, the packaging substrate 220 is made of other materials capable of being used as a part of the flat panel display. The packaging substrate 220 has a resist 322 disposed over and between the non-uniform pillars 306 of at least one die (e.g., a first die 302). The resist 322 to be patterned is sensitive to electromagnetic radiation, for example UV or deep UV "light". A positive resist includes portions of the resist, when exposed to radiation, are respectively soluble to a resist developer applied to the resist 322 after the pattern is written into the photoresist using the electromagnetic radiation. After exposure of the resist to the electromagnetic radiation, the resist is developed to leave a patterned resist 324 over the non-uniform pillars 306. The patterned resist 324 includes vias 330 disposed over each non-uniform pillar 306. Then solder plating is disposed over the patterned resist 324. The solder 323 from the solder plating fills the vias 330 patterned in the patterned resist 324. The patterned resist 324 is then removed forming a portion of the packaging circuitry. In certain embodiments, additional processing may occur such as heating the solder bump 314 disposed over each non-uniform pillar of the plurality of non-uniform pillars 306 before securing the plurality of non-uniform pillars 306 disposed over a die (e.g., a first die 302) to a circuit.

The processing unit 204 is supported by the support 208 such that the processing unit 204 straddles the pair of tracks 216. The support 208 provides an opening 212 for the pair of tracks 216 and the stage 214 to pass under the processing unit 204. The processing unit 204 is a pattern generator configured to receive the mask pattern data from the interface and expose the resist in the digital lithography process using one or more image projection systems 206 operable to project write beams of electromagnetic radiation to the packaging substrate 220. The pattern generated by the processing unit 204 is projected by the image projection systems 206 to expose the resist of the packaging substrate 220 to the mask pattern that is written into the resist. In one embodiment, which can be combined with other embodiments described herein, each image projection system 206 includes a spatial light modulator to modulate the incoming light to create the desired image. Each spatial light modulator includes a plurality of electrically addressable elements that may be controlled individually. Each electrically addressable element may be in an "ON" position or an "OFF" position based on the mask pattern data and corrections provided by positional custom models created through the digital lithography method 400 described herein. When the light reaches the spatial light modulator, the electrically addressable elements that are in the "ON" position project a plurality of write beams to a projection lens (not shown). The projection lens then projects the write beams to the packaging substrate 220. The electrically addressable elements include, but are not limited to, digital micromirrors, liquid crystal displays (LCDs), liquid crystal over silicon (LCoS) devices, ferroelectric liquid crystal on silicon (FLCoS) devices, microshutters, microLEDs, VCSELs, liquid crystal displays (LCDs), or any solid state emitter of electromagnetic radiation.

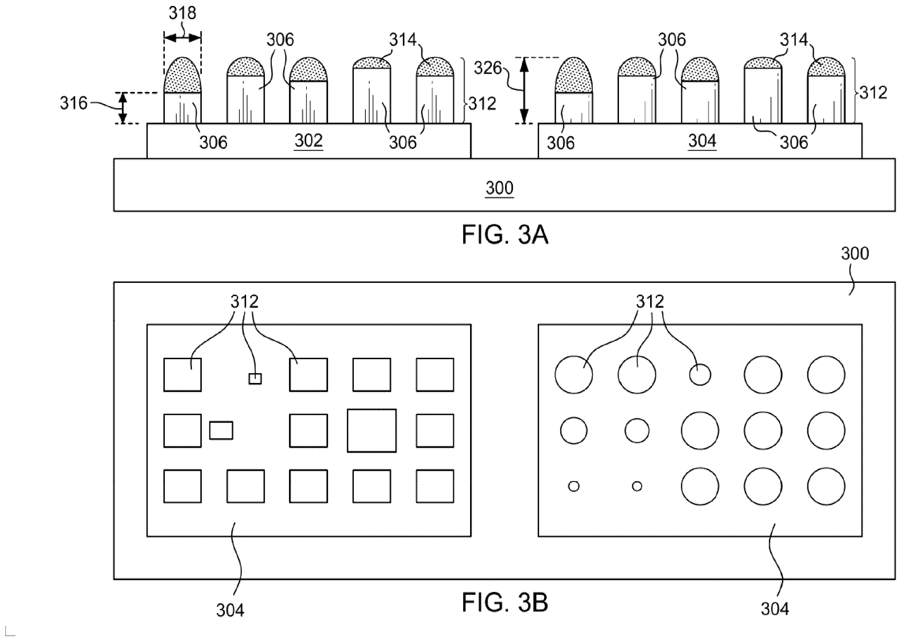

Figures 3A is a schematic, perspective view of a packaging substrate 300 in accordance with one or more embodiments described herein. Figure 3B is a schematic, top view of a packaging substrate 300 in accordance with one or more embodiments described herein. A first die 302 and a second die 304 are disposed over the packaging substrate 300. In other embodiments, additional dies may be disposed over the packaging substrate 300. In further embodiments, one die (e.g., the first die 302) is disposed over the packaging substrate 300. A plurality of non-uniform pillars 306 are disposed over the first die 302 and the second die 304. As shown in Figure 3A, five non-uniform pillars 306 are disposed over each die (e.g., the first die 302 and the second die 304), however, it should be understood that any number of non-uniform pillars 306 may be disposed over each die (e.g., the first die 302 and the second die 304). Each non-uniform pillar of the plurality of non-uniform pillars 306 may include any pillar height 316 or pillar critical dimension 318. A pillar height 316 is at least 5 um. For example, as shown in Figure 3A, the non-uniform pillars 306 include varying pillar heights 316. For a further example, as shown in Figure 3B, the non-uniform pillars 306 may be rectangular or rounded and include varying widths or diameters. Additionally, as shown in Figure 3A and Figure 3B, the non-uniformity is random and localized. The plurality of non-uniform pillars 306 may include a metal material. For example, the non-uniform pillars 306 may include copper or nickel. Further the non-uniform pillars 306 may include multiple layers of metal. For example, the non-uniform pillars 306 may include a layer of copper and a layer of nickel. A solder bump 314 is disposed over each non-uniform pillar in the plurality of non-uniform pillars 306. The solder bump 314 and a non-uniform pillar from the plurality of non-uniform pillars 306 form a structure 312 (e.g., each structure 312 includes a solder bump 314 and a non-uniform pillar of the plurality of non-uniform pillars 306). Each solder bump 314 on each structure 312 may be a different volume. The different volume allows for the uniform height 326 to be uniform across all the structures 312 disposed on a die (e.g., the first die 302). As shown in Figure 3A, each structure 312 disposed on a die (e.g., the first die 302 or the second die 304) includes the same uniform height 326. The uniform height 326 may be any height. For example, the uniform height 326 is at least 10 um

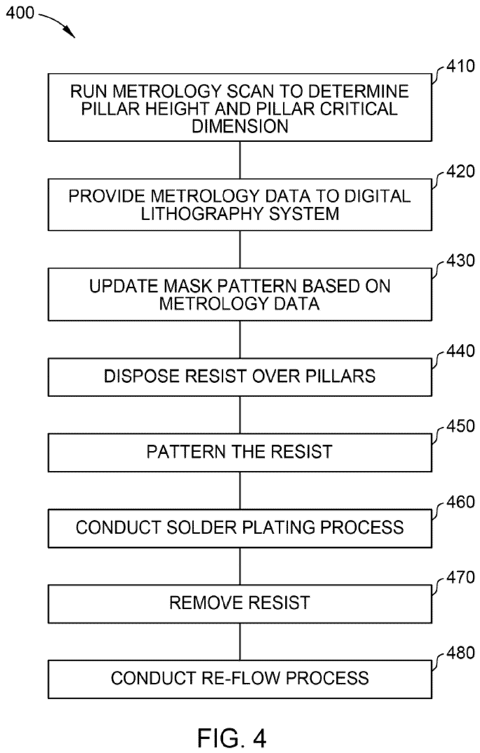

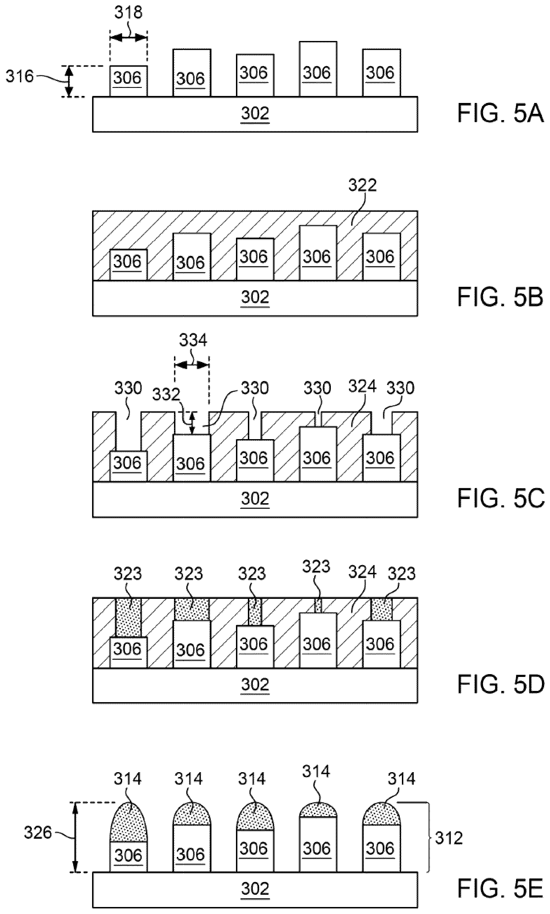

Figure 4 is a flow diagram of a digital lithography method 400 for processing structures 312 in accordance with one or more embodiments described herein. Figures 5A-5E are schematic, perspective views of non-uniform pillars disposed over a die (e.g., a first die 302) during processing operations of a digital lithography method 400 in accordance with one or more embodiments described herein.

At operation 410, a metrology device 104 conducts a metrology scan to determine the pillar height 316 and pillar critical dimension 318 of each of the non-uniform pillars of the plurality of non-uniform pillars 306. As shown in Figure 5A, the plurality of non-uniform pillars 306 are disposed over a first die 302. The metrology device 104 is operable to convert the pillar heights 316 and the pillar critical dimensions 318 into a metrology data format. The metrology data corresponds to the pillar heights 316 and the pillar critical dimensions 318. At operation 420, the metrology data collected during operation 410 is provided to the digital lithography system 100. The metrology data is transferred to the controller 110 via a communication link 101, as shown in Figure 1. The controller 110 is operable to update a mask pattern based on the metrology data generated via the metrology device 104 during operation 410. The mask pattern corresponds to a pattern of structures (e.g., a pattern to form structures 312). At operation 430, the controller 110 updates the mask pattern with the metrology data captured by the metrology device 104. The mask pattern is a custom pattern that is determined by the pillar heights 316 and pillar critical dimensions 318. The metrology data generates a compensated mask pattern based on the different pillar heights 316 and different pillar critical dimensions 318. At operation 440, as shown in Figure 5B, a resist 322 is deposited over and between the non-uniform pillars 306. The resist 322 is at least the height required to achieve structures 312 with a uniform height 326.

At operation 450, as shown in Figure 5C, the resist 322 is patterned with one or more patterns using the digital lithography device 108. The meteorology data collected during operation 410 includes instructions for the digital lithography device 108 to pattern the resist 322 according to the compensated mask pattern generated during operation 420 and operation 430. The compensated mask pattern includes a number of vias 330. The vias 330 are openings patterned in the resist 322. Each via 330 is disposed over a non-uniform pillar of the plurality of non-uniform pillars 306. Each via 330 may be a different size based on the metrology data collected during operation 410. Each via 330 is configured to hold a volume of solder 323 from the solder plating so that the solder 323 contacts a non-uniform pillar of the plurality of non-uniform pillars 306 (e.g., the via 330 includes a via depth 332 that extends from the surface of the resist 322 to the top of the plurality of non-uniform pillars 306 and a via critical dimension 334). The via depth 332 varies based on pillar height 316 and pillar critical dimension 318. As shown in Figure 5C, there are five non-uniform pillars 306 and five vias 330. Each via 330 is a different size corresponding with a different pillar height 316 and pillar critical dimension 318. For example, a non-uniform pillar 306 with a larger pillar height 316 may correspond with a via 330 that includes a smaller volume when compared to a non-uniform pillar 306 with a smaller pillar height 316.

After the resist 322 is patterned with one or more patterns using the digital lithography device 108, the resist 322 is developed during a development process. The pattern is written into the resist 322 using electromagnetic radiation from the digital lithography device 108. A soluble to a resist developer is applied to the resist 322. After the resist 322 is developed, a patterned resist 324 is left over the first die 302. The patterned resist 324 includes the vias 330 described above.

At operation 460, as shown in Figure 5D, a solder plating process is conducted. The solder plating process includes disposing solder 323 into each via 330. The solder plating may include electroplating. The solder 323 disposed into each via includes a volume that is determined by the dimensions of the via 330. The solder 323 disposed into each via 330 forms a solder bump 314. The custom volumes of solder 323 to form each solder bump 314 allow for a secure connection to form between the non-uniform pillars 306 and a circuit (not pictured).

At operation 470, as shown in Figure 5E, the patterned resist 324 is removed. At operation 480, a reflow process is conducted to heat the solder bump 314 over each non-uniform pillar 306. When the solder bump 314 is heated it forms a rounded shape on top of each non-uniform pillar of the plurality of non-uniform pillars 306. The re-flow process allows for planarization of the non-uniform pillars 306. After the re-flow process each of the structures 312 include a uniform height 326. The uniform height 326 can be any height. For example, the uniform height 326 is at least 10 um where each structures 312 includes this uniform height 326.

After the digital lithography method 400 is complete, further processing may occur. For example, the structures 312 are coupled to a circuit. Each solder bump 314 provides the means for a secure connection between the plurality of non-uniform pillars 306 and the circuit. Benefits of the present disclosure include a package assembly having a secure connection between the plurality of non-uniform pillars 306 with varying pillar heights 316 and pillar critical dimensions 318 disposed on a die (e.g., a first die 302) and a circuit. The device and methods of forming the device described herein allows for the manufacturing of a packaging assembly having an increased performance and increased quality, while decreasing the manufacturing time, and manufacturing costs.

A plurality of embodiments are provided by the present disclosure, some of which are listed below.

Embodiment 1. A method comprising: receiving metrology data, the metrology data corresponding to pillar heights and pillar critical dimensions, wherein a digital lithography system including a controller is operable to update a mask pattern, the mask pattern corresponding to a pattern of uniform pillars; updating the mask pattern according to the metrology data to generate a compensated mask pattern based on the pillar heights and the pillar critical dimensions; and conducting a digital lithography process on a resist according to the compensated mask pattern to form a plurality of vias, the vias are formed over each non-uniform pillar of a plurality of non-uniform pillars and include a via depth and a via critical dimension after the resist is developed.

Embodiment 2. The method of embodiment 1, further comprising conducting a solder plating process, the solder plating process filling each via in the plurality of vias with a solder bump, each solder bump secured to one non-uniform pillar of the plurality of non-uniform pillars.

Embodiment 3. The method of any of embodiments 1 to 2, further comprising removing the resist.

Embodiment 4. The method of any of embodiments 1 to 3, further comprising conducting a reflow process, the reflow process shaping a solder bump.

Embodiment 5. The method of any of embodiments 1 to 4, wherein the metrology data is collected by a metrology device, the metrology device including software to measure the pillar heights and the pillar critical dimensions of the plurality of non-uniform pillars.

Embodiment 6. The method of any of embodiments 1 to 5, wherein the digital lithography system comprises: a metrology device; a digital lithography tool; the controller; and a plurality of communication links.

Embodiment 7. The method of any of embodiments 1 to 6, wherein the resist is patterned with a development process, the development process comprising: writing a pattern into the resist; using electromagnetic radiation supplied by a digital lithography device to pattern the resist; and applying a resist developer to the resist, such that the resist is soluble to the resist developer.

Embodiment 8. The method of any of embodiments 1 to 7, wherein the via depth and the via critical dimension correspond to the pillar heights and the pillar critical dimensions.

Embodiment 9. The method of any of embodiments 2 to 8, wherein the solder plating is electroplating.

Embodiment 10. The method of any of embodiments 4 to 9, wherein the reflow process includes heating the solder bump, heating the solder bump rounds the solder bump.

Embodiment 11. The method of any of embodiments 1 to 10, wherein each solder bump and each non-uniform pillar form a structure, each structure includes a uniform height.

Embodiment 12. A method comprising: conducting a metrology scan to determine a pillar height and a pillar critical dimension for each of a plurality of non-uniform pillars disposed over a die, the metrology scan generating metrology data corresponding to the pillar heights and the pillar critical dimensions of the plurality of non-uniform pillars, the metrology data generating a compensated mask pattern; conducting a digital lithography process according to the compensated mask pattern to form a plurality of vias, the vias are formed over each non-uniform pillar of the plurality of non-uniform pillars and include a via depth and via critical dimension; and conducting a solder plating process, the solder plating process filling each via in the plurality of vias with a solder bump, each solder bump secured to one non-uniform pillar of the plurality of non-uniform pillars.

Embodiment 13. The method of embodiment 12, further comprising: depositing a resist over and around the plurality of non-uniform pillars; patterning the resist according to the compensated mask pattern with a development process, the development process comprising: writing a pattern into the resist; using electromagnetic radiation supplied by a digital lithography device to pattern the resist; and applying a resist developer to the resist, such that the resist is soluble to the resist developer.

Embodiment 14. The method of embodiment 13, further comprising removing the resist.

Embodiment 15. The method of any of embodiments 12 to 14, further comprising conducting a reflow process, the reflow process shaping the solder bump.

Embodiment 16. The method of any of embodiments 12 to 15, wherein each solder bump and each non-uniform pillar form a structure, each structure includes a uniform height.

Embodiment 17. A non-transitory computer-readable medium storing instructions that, when executed by a processor, cause a computer system to perform the steps of: receiving metrology data, the metrology data corresponding to pillar heights and pillar critical dimensions, wherein a digital lithography system including a controller is operable to update a mask pattern, the mask pattern corresponding to a pattern of uniform pillars; updating the mask pattern according to the metrology data to generate a compensated mask pattern based on the pillar heights and the pillar critical dimensions; and conducting a digital lithography process to pattern on a resist according to the compensated mask pattern to form a plurality of vias, the vias are formed over each non-uniform pillar of a plurality of non-uniform pillars and include a via depth and a via critical dimension after the resist is developed.

Embodiment 18. The non-transitory computer-readable medium of embodiment 17, further comprising removing the resist.

Embodiment 19. The non-transitory computer-readable medium of any of embodiments 17 to 18, further comprising conducting a solder plating process, the solder plating process filling each via in the plurality of vias with a solder bump, each solder bump secured to one non-uniform pillar of the plurality of non-uniform pillars.

Embodiment 20. The non-transitory computer-readable medium of any of embodiments 17 to 19, wherein each solder bump and each non-uniform pillar form a structure, each structure includes a uniform pillar height.

Embodiment 21. The non-transitory computer-readable medium of any of embodiments 17 to 20, wherein a method of any of embodiments 1 to 16 is performed.

While the foregoing is directed to embodiments of the present disclosure, other and further embodiments of the disclosure may be devised without departing from the basic scope thereof, and the scope thereof is determined by the claims that follow.

## Claims

1. A method comprising:
receiving metrology data, the metrology data corresponding to pillar heights and pillar critical dimensions, wherein a digital lithography system including a controller is operable to update a mask pattern, the mask pattern corresponding to a pattern of uniform pillars;
updating the mask pattern according to the metrology data to generate a compensated mask pattern based on the pillar heights and the pillar critical dimensions; and
conducting a digital lithography process on a resist according to the compensated mask pattern to form a plurality of vias, the vias are formed over each non-uniform pillar of a plurality of non-uniform pillars and include a via depth and a via critical dimension after the resist is developed.

2. The method of claim 1, further comprising conducting a solder plating process, the solder plating process filling each via in the plurality of vias with a solder bump, each solder bump secured to one non-uniform pillar of the plurality of non-uniform pillars.

3. The method of any of claims 1 to 2, wherein the metrology data is collected by a metrology device, the metrology device including software to measure the pillar heights and the pillar critical dimensions of the plurality of non-uniform pillars.

4. The method of any of claims 1 to 2, wherein the digital lithography system comprises:
a metrology device;
a digital lithography tool;
the controller; and
a plurality of communication links.

5. The method of any of claims 1 to 4, wherein the resist is patterned with a development process, the development process comprising:
writing a pattern into the resist;
using electromagnetic radiation supplied by a digital lithography device to pattern the resist; and
applying a resist developer to the resist, such that the resist is soluble to the resist developer.

6. The method of any of claims 1 to 5, wherein the via depth and the via critical dimension correspond to the pillar heights and the pillar critical dimensions.

7. A method comprising:
conducting a metrology scan to determine a pillar height and a pillar critical dimension for each of a plurality of non-uniform pillars disposed over a die, the metrology scan generating metrology data corresponding to the pillar heights and the pillar critical dimensions of the plurality of non-uniform pillars, the metrology data generating a compensated mask pattern;
conducting a digital lithography process according to the compensated mask pattern to form a plurality of vias, the vias are formed over each non-uniform pillar of the plurality of non-uniform pillars and include a via depth and via critical dimension; and
conducting a solder plating process, the solder plating process filling each via in the plurality of vias with a solder bump, each solder bump secured to one non-uniform pillar of the plurality of non-uniform pillars.

8. The method of claim 7, further comprising:
depositing a resist over and around the plurality of non-uniform pillars;
patterning the resist according to the compensated mask pattern with a development process, the development process comprising:
writing a pattern into the resist;
using electromagnetic radiation supplied by a digital lithography device to pattern the resist; and
applying a resist developer to the resist, such that the resist is soluble to the resist developer.

9. The method of any of claims 2 or 7 to 8, further comprising conducting a reflow process, the reflow process shaping the solder bump.

10. The method of any of claims 2 or 7 to 9, wherein the solder plating is electroplating.

11. The method of any of claims 9 to 10, wherein the reflow process includes heating the solder bump, heating the solder bump rounds the solder bump.

12. The method of any of claims 2 or 7 to 11, wherein each solder bump and each non-uniform pillar form a structure, each structure includes a uniform height.

13. The method of any of claims 1 to 6, or 8, further comprising removing the resist.

14. A non-transitory computer-readable medium storing instructions that, when executed by a processor, cause a computer system to perform a method of any of claims 1 to 13.
